# EUROPÄISCHE PATENTSCHRIFT

(11) **EP 1 192 041 B1**
(45) Veröffentlichungstag und Bekanntmachung des Hinweises auf die Patenterteilung: **05.03.2003**
(21) Anmeldenummer: 00979233.4
(22) Anmeldetag: 16.06.2000
(51) Int. Cl.: B29C 67/00, B22F 3/105

(54) **VERFAHREN UND VORRICHTUNG ZUM HERSTELLEN EINES OBJEKTES MITTELS STEREOLITHOGRAPHIE**
METHOD AND DEVICE FOR PRODUCING AN OBJECT BY MEANS OF STEREOLITHOGRAPHY
PROCEDE ET DISPOSITIF PERMETTANT DE PRODUIRE UN OBJET PAR STEREOLITHOGRAPHIE

(30) Priorität: 25.06.1999 DE 19929199
(43) Veröffentlichungstag der Anmeldung: 03.04.2002
(73) Patentinhaber: HAP Handhabungs-, Automatisierungs- und Präzisionstechnik GmbH, 01217 Dresden (DE); Deltamed Medizinprodukte GmbH, 64546 Mörfelden-Walldorf (DE)
(72) Erfinder: POLLACK, Steffen, D-01326 Dresden (DE); GERLOFF, Martin, D-09113 Chemnitz (DE); ZIMMERMANN, Michael, D-65931 Frankfurt (DE)
(74) Vertreter: Prüfer, Lutz H., Dipl.-Phys.
(86) Internationale Anmeldenummer: EP0005559
(87) Internationale Veröffentlichungsnummer: WO01000390

(56) Entgegenhaltungen:
- EP-A- 1 026 564
- US-A- 5 427 733
- US-A- 5 817 206

## Beschreibung

Die Erfindung betrifft ein Verfahren und eine Vorrichtung zur Herstellung eines dreidimensionalen Objektes nach dem Oberbegriff des Patentanspruchs 1 bzw. 8.

Eine Vorrichtung zum Herstellen eines dreidimensionalen Objektes mittels Stereolithographie ist bekannt.

Die Strukturauflösung bei stereolithographisch hergestellten Objekten ist jedoch beschränkt. Bei dem Verfahren der Mikro-Photoverfestigung wird anstelle eines Laserstrahles eine ausgedehnte Lichtquelle verwendet und die selektive Verfestigung entsprechend dem Querschnitt erfolgt der Schicht über eine digital ansteuerbare Maske in Form einer Transmissions-Flüssigkristallplatte. Das Verfahren der Mikro-Photoverfestigung ermöglicht eine höhere Strukturauflösung durch eine verkleinernde Projektion der Belichtungsmaske auf die Polymeroberfläche. Bei dem Verfahren der Mikro-Photoverfestigung werden, bedingt durch die höhere mögliche Strukturauflösung, höhere Anforderungen an die Genauigkeit der Belichtung gestellt. Insbesondere Bereiche einer Schicht, die nicht mit zuvor verfestigten Schichten verbunden werden, weil sie beispielsweise einen Hohlraum überbrücken oder einen Überhang bilden, stellen hohe Anforderungen an die Genauigkeit der Belichtung.

Aus der US 5,817,206 ist ein Verfahren und eine Vorrichtung zum Herstellen eines dreidimensionalen Objekts durch schichtweises Verfestigen eines unter Einwirkung elektromagnetischer Strahlung verfestigbaren Pulvermaterials an dem Querschnitt des Objekts in der jeweiligen Schicht entsprechenden Stellen unter Verwendung eines Lasers bekannt, wobei der Laserstrahl selektiv an die zu bestrahlenden Stellen abgelenkt wird und wobei der Laser einen steuerbaren Leistungsausgang aufweist.

Es ist Aufgabe der Erfindung, eine verbesserte Vorrichtung zur Herstellung eines dreidimensionalen Objektes unter Verwendung einer Maske bereitzustellen, mit der Objekte mit höherer Strukturauflösung hergestellt werden können.

Die Aufgabe wird gelöst durch ein Verfahren bzw. eine Vorrichtung nach Patentanspruch 1 bzw. 8. Weiterbildungen der Erfindung sind in den Unteransprüchen angegeben.

Weitere Merkmale und Zweckmäßigkeiten der Erfindung ergeben sich aus der Beschreibung eines Ausführungsbeispieles anhand der Figuren.

### Von den Figuren zeigen:

- Fig. 1: eine schematische Querschnittsansicht der Vorrichtung; und
- Fig. 2: eine schematische Darstellung eines zu bildenden Objekts.

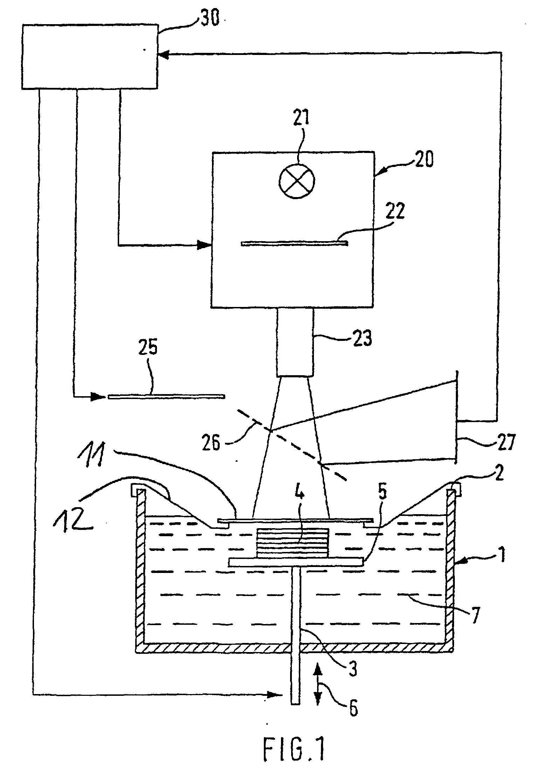

Wie aus Figur 1 ersichtlich ist, weist die Vorrichtung einen an seiner Oberseite offenen Behälter 1 mit einem oberen Rand 2 auf. In dem Behälter ist ein Träger 3 zum Tragen eines zu bildenden Objektes 4 mit einer im wesentlichen ebenen und horizontal ausgerichteten Bauplattform 5 angeordnet, die mittels einer schematisch angedeuteten Höheneinstellvorrichtung 6 in dem Behälter 1 auf und ab verschoben und.positioniert werden kann. Die Bauplattform 5 weist einen kreisförmigen Querschnitt auf. Der gesamte Behälter 1 ist bis zu einem Niveau bzw. einer Oberfläche unterhalb des oberen Randes 2 mit einem lichtaushärtbaren flüssigen Kunststoff 7 gefüllt.

In einem vorbestimmten Abstand unterhalb des oberen Randes 2 des Behälters 1 ist eine ebene transparente Platte 11 aus einem für sichtbares Licht transparentem Material, beispielsweise aus weißem Glas, vorgesehen, die über eine Halterung 12 derart an der Vorrichtung befestigt ist, daß sie bei mit dem Material gefüllten Behälter um ein vorbestimmtes Maß in das Material eintaucht. Die Halterung 12 ist über einen Antrieb über dem Behälter 1 verschiebbar und an einer gewünschten Position über der Bauplattform 5 positionierbar. Die transparente Platte 11 ist ferner über eine Justiereinrichtung in ihrer Neigung und Höhe justierbar, so daß sie senkrecht zur optischen Achse einer später beschriebenen Belichtungseinrichtung und parallel zur Bauplattform ausgerichtet werden. An ihrer der Oberseite der Bauplattform 5 zugewandten Unterseite ist die transparente Platte 11 mit einem Material beschichtet, an dem das Kunststoffmaterial 7, wenn es durch Einwirkung elektromagnetischer Strahlung verfestigt ist, nicht anhaftet.

Oberhalb des Behälters 1 ist eine Belichtungseinrichtung 20 in Form eines an sich bekannten LCD-Projektors (Flüssigkristall-Display-Projektors) vorgesehen. Die Belichtungseinrichtung 20 weist eine Lichtquelle 21 zur Erzeugung von sichbarem Licht, beispielsweise in Form einer Halogenlampe, auf sowie eine zwischen der Lichtquelle 21 und dem Behälter 1 angeordnete Maskenerzeugungseinrichtung 22 in Form eines Flüssigkristall (LC)-Displays bzw. einer Flüssigkristallplatte. Zwischen der Lichtquelle 21 und dem LC-Display ist eine nicht dargestellte Projektionsoptik zum homogenen Ausleuchten des LC-Displays vorgesehen. Das LC-Display ist als Transmissions-LC-Display mit hoher Auflösung, beispielsweise 800x600 Pixel und 256 Graustufen ausgebildet, welches in Abhängigkeit von Daten, die den Querschnitt des zu bildenden Objektes in der jeweiligen Schicht definieren, ansteuerbar ist. Das LC-Display bildet somit eine Maske für die Belichtung in der jeweiligen Schicht. Das LC-Display ist ferner derart ausgebildet, daß jedes Pixel so ansteuerbar ist, daß es eine gewünschte Durchlässigkeit zwischen 0 und 100%, der auftreffenden Lichtleistung besitzt, indem die einzelnen Graustufen angesteuert werden.

Die Belichtungseinrichtung weist ferner eine zwischen dem LC-Display und dem Behälter 1 angeordnete Optik 23 in Form eines Zoom-Objektivs zum verkleinerten bzw. vergrößerten Abbilden der durch das LC-Display erzeugten Maske auf die transparente Platte 11 auf. Bevorzugt ist die Optik 23 als Verkleinerungsoptik mit einstellbarer Verkleinerung ausgebildet, die es ermöglicht, durch verkleinerte Abbildung der Maske eine hohe Strukturauflösung zu erhalten. Die Anordnung der Belichtungseinrichtung 20 und der transparenten Platte 11 relativ zueinander ist so, daß die Brennebene der Optik 23 mit der Unterseite der transparenten Platte 11 zusammenfällt, so daß dort eine scharfe Abbildung erzeugt wird.

Wie aus Figur 1 ersichtlich ist, ist in dem Strahlengang zwischen der Belichtungseinrichtung 20 und dem Behälter 1 eine Abschattungseinrichtung in Form einer Blende 25 zum Abblenden des Lichtes vorgesehen. Die Blende 25 ist über eine schematisch angedeutete Schwenkvorrichtung in den Strahlengang hinein- und wieder herausschwenkbar.

In dem Strahlengang ist ferner ein halbdurchlässiger Spiegel 26 unter 45° zur optischen Achse angeordnet, wodurch ein Teil der Lichtstrahlen des Abbildungsstrahlenganges ausgeblendet wird. Es ist ferner ein Detektor 27 vorgesehen, mit dem das über den halbdurchlässigen Spiegel 26 ausgeblendete Licht aufgefangen wird. Da es sich bei dem ausgeblendeten Licht um ein Abbild der Maske handelt ist ein flächiger Detektor erforderlich. Beipielsweise ist der Detektor 27 als CCD-Kamera ausgebildet.

Die gesamte Belichtungseinrichtung 20 ist über einen Antrieb in vertikaler Richtung verschiebbar, so daß der Abstand zwischen dem LC-Display und der transparenten Platte zur Einstellung eines zu belichtenden Feldes einstellbar ist.

Es ist ferner eine Steuerung 30 mit einem Computer vorgesehen, die so ausgebildet ist, daß sie die Maskenerzeugungseinrichtung 22 in der Belichtungseinrichtung 20, die Höheneinstellvorrichtung 6 und die Blende 25 zentral und in Abhängigkeit von einem von den Objektdaten abhängigen Bauprogramm steuert. Die Steuerung 30 ist derart ausgebildet, daß sie in Abhängigkeit von den Daten, die jeweils den Querschnitt des zu bildenden Objektes in einer Schicht kennzeichnen, die Maskenerzeugungseinrichtung 22 ansteuert. Ferner ist die Steuerung 30 so ausgebildet, daß die Bauplattform 5 schrittweise um das einer Schichtdicke entsprechende Maß relativ zu der Unterseite der transparenten Platte 11 absenkbar ist und daß die Blende 25 in den Strahlengang eingeschwenkt wird, wenn keine Belichtung der Oberfläche des Kunststoffes stattfinden soll bzw. daß die Blende 25 aus dem Strahlengang herausgeschwenkt wird, bevor die Belichtung einer Schicht beginnt.

Bei dem erfindungsgemäßen Verfahren werden zuerst aus vorgegebene Objektdaten, beispielsweise CAD-Daten, in bekannter Weise Schichtdaten für den Querschnitt des Objektes in jeder Schicht erzeugt. Dann wird in einem ersten Schritt der Behälter 1 mit dem flüssigen Kunststoff 7 gefüllt. Als Kunststoff wird ein Polymer verwendet, welches unter Einwirkung von sichtbarem Licht aushärtet. Die transparente Platte 11 wird so justiert, daß sie horizontal an einer vorgegebenen Stelle über der Bauplattform 5 und parallel zu dieser, sowie senkrecht zur optischen Achse der Belichtungseinrichtung angeordnet ist. In einem zweiten Schritt wird über die Höheneinstellvorrichtung 6 der Träger derart verschoben, daß sich die Oberfläche der Bauplattform 5 um das der gewünschten Schichtdicke entsprechende Maß unterhalb der Unterseite der transparenten Platte 11 befindet. Damit befindet sich zwischen der Oberseite der Bauplattform 5 und der Unterseite der transparenten Platte 11 eine Schicht des flüssigen lichtaushärtbaren Kunststoffes.

Anschließend erfolgt die Belichtung der ersten Schicht. Das LC-Display wird über die Steuerung 30 entsprechend den der ersten zu verfestigenden Schicht des Objektes entsprechenden Schichtdaten angesteuert, so daß das LC-Display eine Maske bildet; die das von der Lichtquelle 2 ausgesandte Licht an den Stellen hindurchläßt, die dem Querschnitt des Objektes in dieser Schicht entsprechen und an den übrigen Stellen undurchlässig ist. Durch das mittels der Optik 23 auf die transparente Platte 11 projizierte Bild der Maske erfolgt eine Bestrahlung der unterhalb der transparenten Platte 11 befindlichen Schicht des flüssigen Kunststoffmaterials lediglich an den Stellen, die dem Bild entsprechen.

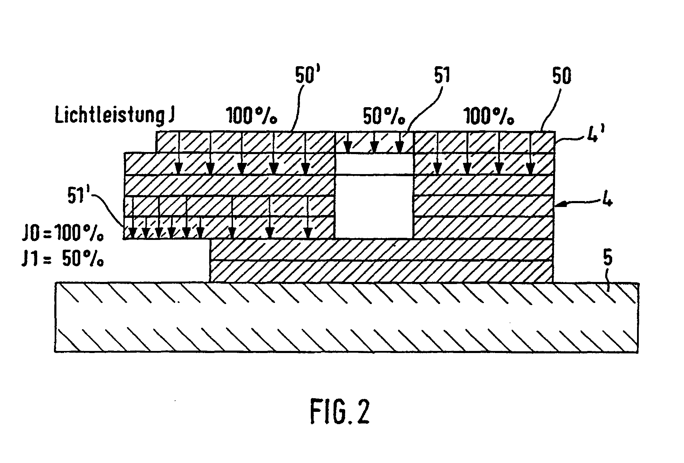

Das Bauprogramm für das zu bildende Objekt erzeugt zu den Schichtdaten des Querschnitts des zu bildenden Objekts in Abhängigkeit von den Objektdaten in jeder Schicht eine Zusatzinformation, in der, wie anhand Fig. 2 ersichtlich ist, angegeben ist, welche Bereiche 50, 50' der zu bildenden Schicht mit darunterliegenden verfestigten Bereichen zu verbinden sind und welche Bereiche 51, 51' über nichtverfestigten darunterliegenden Bereichen einer Schicht zu bilden sind. Fig. 2 ist eine schematische Darstellung eines im Aufbau befindlichen Objektes 4 bei dem in der obersten verfestigten Schicht 4' der Bereich 51 einen darunterliegenden Hohlraum überbrückt, der während des Aufbaus unverfestigtes Material enthält und bei dem der Bereich 51' den Beginn eines überhängenden bzw. auskragenden Teiles des zu bildenden Objekts darstellt. Anhand dieser Zusatzinformation in den Schichtdaten wird über die Steuerung 30 das LC-Display 22 derart angesteuert, daß Bereiche 50, 50', die sich über bereits verfestigten Bereichen mit einer Lichtintensität I0 belichtet werden, die ausreicht, diesen Bereich der Schicht zu durchdringen und ihn mit dem darunterliegenden Bereich zu verbinden. Die Bereiche 51, 51' werden mit einer Lichtintensität I1 belichtet, die im Vergleich zu I0 um bis zu 50% reduziert ist, was über die Graustufen des LC-Displays eingestellt wird. Damit wird gewährleistet, daß der zu verfestigende Bereich 51, 51' nur bis zu einer Tiefe einer Schichtdicke ausgehärtet wird. Es lassen sich über die Graustufenbelichtung aber auch beliebige andere Lichtintensitäten auf einfache Weise einstellen

Das Intensitätsprofil einer Schicht wird über den Detektor 27 erfaßt und zur Steuerung der Belichtung der darauf folgenden Schicht oder nachfolgender Objekte verwendet. Anhand des gemessenen Intensitätsprofils kann das tatsächlich auf die Schicht auftreffende Intensitätsprofil ermittelt werden und anschließend entweder die Belichtungszeit oder die Lichtintensität über die LCD (Graustufen) und/oder die Lichtquelle gesteuert werden. Die Ermittlung der Lichtintensität über den Spiegel und den Detektor dient auch zur Kompensation einer auftretenden Abnahme der Lampenleistung, die manchmal bereits nach 10% - 20% der maximalen Lampenlebensdauer auftritt.

Nach der Belichtung einer Schicht wird die Blende 25 in den Strahlengang geschwenkt, um zu verhindern, daß während der Einstellung der nächsten Schicht Licht auf das Kunststoffmaterial in dem Behälter fällt und dieses an nicht gewünschten Stellen verfestigt wird. Anschließend wird die Bauplattform 5 um das einer Schichtdicke entsprechende Maß abgesenkt. Beim Absenken der Bauplattform 5 entsteht zwischen der fest angeordneten transparenten Platte 11 und der letzten belichteten und damit ausgehärteten Schicht ein Unterdruck, der dafür sorgt, das Kunststoffmaterial in den so erzeugten Zwischenraum zwischen der transparenten Platte 11 und der zuletzt verfestigten Schicht nachfließt. Nach Einstellung der neuen Schicht werden die oben beschriebenen Schritte bis zur Fertigstellung des Objektes wiederholt.

Durch die Einstellung der Lichtintensität über die Graustufenbelichtung und die hohe Auflösung des LC-Displays ist es möglich, höchste Strukturauflösungen, insbesondere bei Objekten mit Außenabmessungen im Millimeterbereich oder darunter zu erhalten.

In einer alternativen Ausführungsform wird als Maskenerzeugungseinrichtung nicht ein LC-Display verwendet, sondern ein digital angesteuertes Spiegelsystem (Digital Mirror Display) oder ein Laser-Projektions-Display bzw. eine Lasermaske.

In einer weiteren Ausführungsform des erfindungsgemäßen Verfahrens wird die Intensitätssteuerung des Belichtungslichtes über die Steuerung der Maske dazu verwendet, aufeinanderfolgende Schichten mit gleichem Querschnitt auf einmal auszuhärten, indem die Lichtintensität erhöht wird.

Allgemein erlaubt die Steuerung der Lichtintensität und damit des Energieeintrags in das zu verfestigende Material über die digitale d.h. pixelweise Steuerung der Durchlässigkeit der Maske sowohl die Steuerung der Verfestigungstiefe innerhalb einer Schicht, als auch über mehrere Schichten hinweg.

## Patentansprüche

1. Verfahren zum Herstellen eines dreidimensionalen Objektes durch schichtweises Verfestigen eines unter Einwirkung elektromagnetischer Strahlung oder Teilchenstrahlung verfestigbaren Materials (7) an dem Querschnitt des Objekts in der jeweiligen Schicht entsprechenden Stellen unter Verwendung einer in Abhängigkeit von dem Querschnitt des Objektes in der jeweiligen Schicht ansteuerbaren Maskenerzeugungseinrichtung (22) zum Erzeugen einer Maske zum selektiven Hindurchlassen der elektromagnetischen oder der Teilchenstrahlung,
**dadurch gekennzeichnet,**
**daß** die Intensität der Strahlen innerhalb zu bestrahlender Bereiche über die Steuerung der Durchlässigkeit der Maske für die Strahlung gesteuert wird.

2. Verfahren nach Anspruch 1 **dadurch gekennzeichnet, daß** die Intensität verringert wird, wenn der zu bestrahlende Bereich über einen Bereich mit nicht verfestigtem Material (7) einer darunterliegenden Schicht liegt.

3. Verfahren nach Anspruch 2, **dadurch gekennzeichnet, daß** die Intensität zwischen 5% und 60% einer Intensität reduziert wird, die erforderlich ist, um eine Schicht bei der Verfestigung mit der darunterliegenden Schicht zu verbinden.

4. Verfahren nach einem der Ansprüche 1 bis 3, **dadurch gekennzeichnet, daß** ein Intensitätsprofil der Strahlung über die Schicht bei der Bestrahlung einer Schicht gemessen wird und das Intensitätsprofil bei der Ansteuerung der Maske für die nächste zu verfestigende Schicht verwendet wird.

5. Verfahren nach einem der Ansprüche 1 bis 4, **dadurch gekennzeichnet, daß** als Maskenerzeugungseinrichtung (22) ein Transmissions-LC-Display mit Graustufen verwendet wird, wobei die Steuerung der Intensität über die Ansteuerung der Graustufen erfolgt.

6. Verfahren nach einem der Ansprüche 1 bis 5, **dadurch gekennzeichnet, daß** als elektromagnetische Strahlung sichtbares Licht verwendet wird.

7. Verfahren nach Anspruch 6, **dadurch gekennzeichnet, daß** als verfestigbares Material (7) ein Polymer, welches unter Einwirkung sichtbaren Lichtes aushärtet.

8. Vorrichtung zum Herstellen eines dreidimensionalen Objektes durch schichtweises Verfestigen eines unter Einwirkung elektromagnetischer oder Teilchenstrahlung verfestigbaren Materials an dem Querschnitt des Objektes (4) entsprechenden Stellen mit
einer Einrichtung (21) zum Erzeugen der elektromagnetischen oder der Teilchenstrahlung,
einer Objekttrageeinrichtung (5) zum Tragen des zu bildenden Objektes,
einer Einrichtung zum Aufbringen einer Schicht des Material auf die Trageeinrichtung oder eine zuvor gebildete Schicht, einer Maskenerzeugungseinrichtung (22) zum Erzeugen einer Maske zum selektiven Hindurchlassen der elektromagnetischen oder der Teilchenstrahlung an den dem Querschnitt des Objektes in der Schicht entsprechenden Stellen; und
einer Steuereinrichtung (30) zum Steuern der Maskenerzeugungseinrichtung, die so ausgebildet ist, daß sie die Intensität der durch die Maske hindurchgelassenen Strahlung in Abhängigkeit von einer vorgegebenen Verfestigungstiefe über die Durchlässigkeit der Maske für die Strahlungsteuert steuert.

9. Vorrichtung nach Anspruch 8, **gekennzeichnet durch** eine zwischen der Einrichtung zum Erzeugen der elektromagnetischen Strahlung oder der Teilchestrahlung angeordnete Ablenkeinrichtung (26), die wenigstens einen Teil der **durch** die Maske hindurchgelassenen Strahlung ablenkt und eine Detektoreinrichtung (27) zum Erfassen eines Intensitätsprofils der über die Ablenkeinrichtung abgelenkten Strahlung.

10. Vorrichtung nach Anspruch 8 oder 9, **dadurch gekennzeichnet, daß** die Erzeugungseinrichtung (21) für die elektromagnetische Strahlung eine Lichtquelle für sichtbares Licht ist und die Maskenerzeugungseinrichtung (22) als Transmissions-LC-Display ausgebildet ist.

11. Vorrichtung nach Anspruch 10, **dadurch gekennzeichnet, daß** das LC-Display eine Graustufenauflösung aufweist.

## Claims

1. Method of producing a three-dimensional object by layer-by-layer solidifying of a material (7), solidifiable under the action of electromagnetic radiation or particle radiation, at places corresponding to the cross-section of the object in the respective layer by using a mask-generating device (22) which can be controlled in dependence on the cross-section of the object in the respective layer for generating a mask for selectively transmitting the electromagnetic or particle radiation, **characterized in that** the intensity of the beams is controlled within areas to be irradiated via control of the transparency of the mask for the radiation.

2. Method according to claim 1, **characterized in that** the intensity is reduced if the area to be irradiated is located above an area with non-solidified material (7) of a layer located beneath.

3. Method according to claim 2, **characterized in that** the intensity is reduced between 5% and 60% of an intensity which is required to connect a layer during solidification with the layer located beneath.

4. Method according to one of claims 1 to 3, **characterized in that** an intensity profile of the radiation across the layer during irradiation of a layer is measured and the intensity profile is used in controlling the mask for the next layer to be solidified.

5. Method according to one of claims 1 to 4, **characterized in that** a transmission LC display with gray scales is used as mask-generating device (22), wherein control of the intensity takes place via controlling of the gray scales.

6. Method according to one of claims 1 to 5, **characterized in that** visible light is used as electromagnetic radiation.

7. Method according to claim 6, **characterized in that** a polymer which hardens under the action of visible light is used as solidifiable material (7).

8. Device for producing a three-dimensional object by layer-by-layer soidifying of a material, solidifiable under the action of electromagnetic or particle radiation, at places corresponding to the cross-section of the object (4) with
a device (21) for producing the electromagnetic or the particle radiation,
an object carrying device (5) for carrying the object to be formed,
a device for depositing a layer of the material on the carrying device or a previously formed layer,
a mask-generating device (22) for generating a mask for selectively transmitting the electromagnetic or particle radiation at the places corresponding to the cross-section of the object in the layer and
a control device (30) for controlling the mask-generating device, which is constructed such that it controls the intensity of the radiation transmitted by the mask in dependence on a predetermined solidification depth via the transparency of the mask for the radiation.

9. Device according to claim 8, **characterized by** a deflection device (26), arranged between the device for generating the electromagnetic radiation or the particle radiation, which deflects at least a part of the radiation transmitted by the mask, and a detector device (27) for ascertaining an intensity profile of the radiation deflected via the deflection device.

10. Device according to claim 8 or 9, **characterized in that** the generating device (21) for the electromagnetic radiation is a light source for visible light and the mask-generating device (22) is constructed as a transmission LC display.

11. Device according to claim 10, **characterized in that** the LC display has a gray scale resolution.

## Revendications

1. Procédé de fabrication d'un objet tridimensionnel par durcissement par couches d'un matériau (7) susceptible de se durcir sous l'effet d'un rayonnement électromagnétique ou d'un rayonnement de particules à des emplacements correspondants de la couche concernée dans la section transversale de l'objet avec utilisation d'un dispositif (22) de création de masque susceptible d'être commandé en fonction de la section transversale de l'objet dans la couche pour la réalisation d'un masque pour le passage sélectif du rayonnement électromagnétique ou du rayonnement de particules, **caractérisé en ce que**:
- l'intensité du rayonnement à l'intérieur de la zone soumise à rayonnement est commandée par commande de perméabilité du masque pour le rayonnement.

2. Procédé selon la revendication 1, **caractérisé en ce que** l'intensité est diminuée lorsque la zone à soumettre à rayonnement se trouve au-dessus d'une zone avec matériau non durci (7) d'une couche sous-jacente.

3. Procédé selon la revendication 2, **caractérisé en ce que** l'intensité est diminuée de 5 à 60% de l'intensité nécessaire pour relier une couche, lors de la solidification, avec la couche sous-jacente.

4. Procédé selon l'une des revendications 1 à 3, **caractérisé en ce que** le profil d'intensité du rayonnement sur la couche, lors de l'irradiation d'une couche, est mesuré et le profil d'intensité est utilisé lors de la commande du masque pour la couche suivante durcir.

5. Procédé selon l'une des revendications 1 à 4, **caractérisé en ce qu'**on utilise, en tant que dispositif de création de masque (22), un afficheur à cristaux liquides fonctionnant par transmission avec des niveaux de gris, la commande de l'intensité étant effectuée grâce à la commande des niveaux de gris.

6. Procédé selon l'une des revendications 1 à 5 , **caractérisé en ce qu'**on utilise, en tant que rayonnement électromagnétique, la lumière visible.

7. Procédé selon la revendication 6, **caractérisé en ce qu'**on utilise en tant que matériau durcissable (7), un polymère qui se durcit sous l'effet de la lumière visible.

8. Dispositif pour la réalisation d'un objet tridimensionnel par solidification par couches d'un matériau durcissable par rayonnement électromagnétique ou rayonnement de particules à des emplacements correspondants de la section transversale de l'objet (4), avec
- un dispositif (21) pour la création du rayonnement électromagnétique ou du rayonnement de particules,
- un dispositif porte-objet (5) pour supporter l'objet à créer,
- un dispositif pour application d'une couche du matériau sur le dispositif de support ou sur une couche créée précédemment,
- un dispositif de création de masque (22) pour la création de masque pour le passage sélectif du rayonnement électromagnétique ou de particules à des emplacements correspondant à la section transversale de l'objet dans la couche; et
- un dispositif de commande (30) pour la commande du dispositif de création de masque qui est réalisé de façon à commander via la perméabilité du masque pour le rayonnement, l'intensité du rayonnement traversant le masque en fonction d'une profondeur de solidification prédéterminée.

9. Dispositif selon la revendication 8, **caractérisé par** un dispositif de déviation (26) disposé entre le dispositif de création du rayonnement électromagnétique ou du rayonnement de particule, susceptible de dévier au moins une partie du rayonnement traversant le masque, ainsi qu'un dispositif de détection (27) pour détecter un profil d'intensité du rayonnement dévié par le dispositif de déviation.

10. Dispositif selon la revendication 8 ou 9, **caractérisé en ce que** le dispositif de création (21) du rayonnement électromagnétique est une source de lumière pour lumière visible et le dispositif de création de masque (22) est réalisé sous forme d'un afficheur à cristaux liquides fonctionnant par transmission.

11. Dispositif selon la revendication 10, **caractérisé en ce que** l'afficheur à cristaux liquides présente une résolution par niveaux de gris.
